# EUROPÄISCHE PATENTANMELDUNG

(11) **EP 0 553 477 A2**
(43) Veröffentlichungstag der Anmeldung: **04.08.1993**
(21) Anmeldenummer: 92121601.6
(22) Anmeldetag: 18.12.1992
(51) Int. Cl.: H05K 13/04, H01L 21/00

(54) **Mit Bauelementen zu bestückende Leiterplatte**

(30) Priorität: 30.01.1992 DE 4202624
(71) Anmelder: SIEMENS AKTIENGESELLSCHAFT, D-80333 München (DE)
(72) Erfinder: Johannsen, Bernd, Dipl.-Ing., W-8400 Regensburg (DE)

(57) **Zusammenfassung**

Auf ihrer Oberseite und gegebenenfalls auch auf ihrer Unterseite wird eine Leiterplatte 1 mit einer Maske 2 versehen, die Öffnungen 3 sind den Abmessungen und der genauen Lage der einzelnen Bauelemente 4 auf der Leiterplatte 1 angepaßt. Sie weisen schräge Führungsflächen 5 auf, die eine genaue und einfache Positionierung des einzelnen Bauelements an dem vorgesehenen Ort auf der Leiterplatte ermöglichen.

## Beschreibung

Die Erfindung betrifft eine mit Bauelementen zu bestückende Leiterplatte.

Die Bestückung von Leiterplatten mit elektronischen Bauelementen wird durch die zunehmend fortschreitende Miniaturisierung der Bauelemente immer schwieriger. Die dadurch steigenden Kosten können in naher Zukunft einen wirtschaftlichen Einsatz solcher Leiterplatten gefährden. Zum Bestücken der Leiterplatten mit den Bauelementen werden komplizierte Bestückungsautomaten verwendet (vergleiche DE-A 28 34 836).

Um die teilweise äußerst kleinen Bauelemente exakt auf dem für sie vorgesehenen Ort auf der Leiterplatte zu plazieren, müssen optoelektronische Einrichtungen, z.B. Fernsehkameras, eingesetzt werden (Schiebel, Günter "Fine-Pitch-Bestückung im SMT-Prozeß", Vortrag auf dem 1. Internationalen Kongreß SMT/ASIC/Hybrid 91, Messezentrum Nürnberg, 12.06.1991). Derartige optoelektronische Hilfsmittel sind aber recht aufwendig.

Bei einer bekannten Transporthalterung zum Übertragen von elektrischen oder elektronischen Teilen auf eine Leiterplatte wird das durch einen Vakuumstift festgehaltene Bauelement in einem Zentrierblock, der aus einer Zentrierplatte mit Zentrieröffnungen, einer elastischen Platte und einer Stützplatte besteht, auf die Achse des Vakuumstifts ausgerichtet (DE-A 31 44 879). Der Zentrierblock stellt einen zusätzlichen apparativen Aufwand dar, außerdem bedingt der Zentriervorgang selbst zusätzlichen Arbeits- und Zeitaufwand.

Der Erfindung liegt die Aufgabe zugrunde, auch sehr kleine Bauelemente mit geringem Aufwand exakt auf einer Leiterplatte zu positionieren.

Diese Aufgabe wird erfindungsgemäß durch die Leiterplatte nach Anspruch 1 gelöst.

Zweckmäßige Weiterbildungen der Erfindung ergeben sich aus den Unteransprüchen.

Die Vorteile der Erfindung liegen insbesondere darin, daß nachträgliche kostenintensive Prüfungen auf Plaziergenauigkeit der Bauelemente vermieden werden können. Teilweise kann auch durch die erfindungsgemäß zum Positionieren verwendete Maske ein Gehäuse zum Umschließen der fertig bestückten Leiterplatte eingespart werden.

Ausführungsbeispiele der Erfindung werden am folgenden anhand der Zeichnung erläutert. Es zeigen:
- Figur 1: eine erfindungsgemäße Leiterplatte in einer Teil-Schnittansicht,
- Figur 2: eine andere erfindungsgemäße Leiterplatte in einer Teil-Draufsicht,
- Figur 3: ein Produktionsablauf beim Herstellen einer erfindungsgemäßen Leiterplatte, in schematischer Form, und
- Figur 4: eine andere Ausführung einer Maske für eine erfindungsgemäße Leiterplatte.

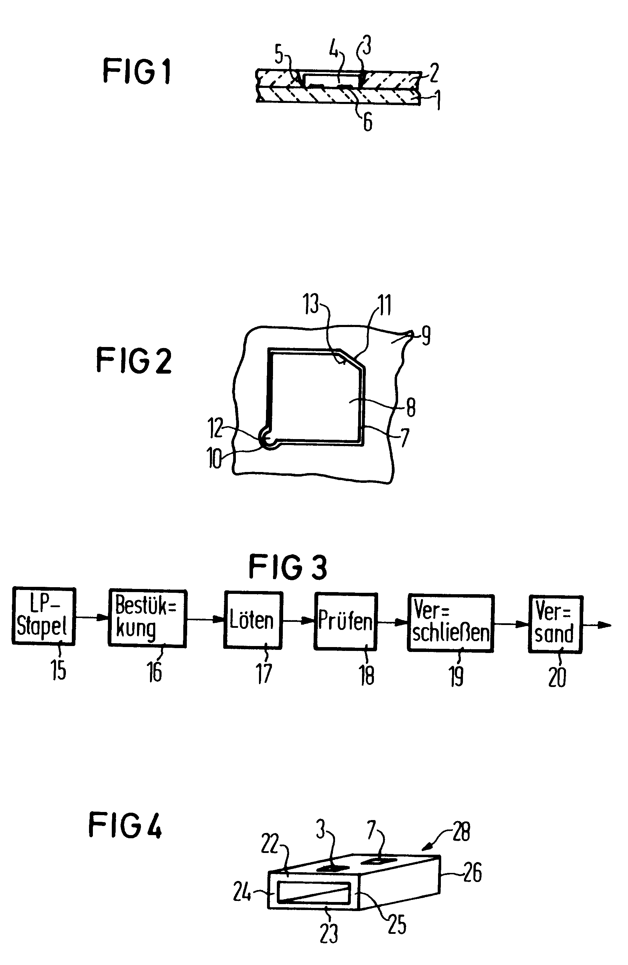

Eine Leiterplatte 1, von der in Figur 1 nur ein kleiner Ausschnitt dargestellt ist, ist aus einem keramischen Werkstoff, z.B. Al₂O₃, oder aus einem faserverstärkten Kunststoff hergestellt. Auf ihrer Oberseite ist eine Maske 2 befestigt, die mit einer Öffnung 3 versehen ist. Diese Öffnung 3 entspricht in ihrer Form und in ihren Abmessungen der Kontur und den Abmessungen eines Bauelementes 4, z.B. eines sogenannten Chips.

Die Öffnung 3 weist eine oder mehrere Führungsflächen 5 auf, die eine Verkleinerung oder Verjüngung der Öffnung 3 in Richtung auf die Oberfläche der Leiterplatte 2 ergeben. Somit wird das Bauelement 4, wenn es zum Beispiel von einem Bestückungsautomaten ungefähr an dem vorgesehenen Ort abgesetzt wird, exakt in die richtige Position auf der Leiterplatte gebracht.

Auf der Oberfläche der Leiterplatte sind Lotdepots 6 vorhanden, die zum nachfolgenden Befestigen und Kontaktieren des Bauelements 4 mit den auf der Leiterplatte vorhandenen Leiterbahnen dienen.

Die Leiterplatte 1 kann auch an ihrer Unterseite mit einer entsprechenden Maske versehen werden, die hier nicht dargestellt ist. Die Maske 2 enthält neben der dargestellten Öffnung 3 eine Vielzahl weiterer Öffnungen, die von der jeweiligen Schaltungsanordnung und den zugehörigen Bauelementen auf der Leiterplatte abhängen. Auch die Passung, das heißt das jeweilige Spiel zwischen der Öffnung 3 und dem Bauelement 4 hängt von den Einzelheiten des jeweiligen Produkts ab.

Um ein, insbesondere bei symmetrischen Bauelementen mögliches, Aufsetzen eines Bauelements mit falscher Polung auf der Leiterplatte zu verhindern, ist ein Bauelement 8 in eine Öffnung 7 einer Maske 9 (Figur 2) eingesetzt, die mit einer oder zwei Lagefixierungen 10 und 11 versehen ist. Diese Lagefixierungen können als runde Aufnahme (10) ausgeführt sein, in die eine entsprechende Ausbuchtung 12 des Bauelements eingreift oder auch als angeschrägter Eckbereich (11) an dem eine entsprechende Anschrägung 13 des Bauelements 8 anliegt. Beide Lagefixierungen 10 und 11 verhindern, daß ein Bauelement in verdrehter Lage und damit mit falsch gepolten Anschlüssen auf der Leiterplatte montiert wird.

Die Masken 2 oder 9 können entweder bereits bei der Herstellung der Leiterplatten auf diesen angebracht werden, oder sie werden vor dem Bestücken der Leiterplatten auf diesen angebracht. Ein Beispiel für ein Verfahren zur Herstellung von Baugruppen, die aus mit elektrischen und elektronischen Bauelementen bestückten Leiterplatten bestehen, ergibt sich aus der systematischen Darstellung eines Produktionsablaufs in Figur 3. Aus einem Stapel 15 werden mit Masken versehene Leiterplatten entnommen und in einer Bestückungsstation 16 mit elektronischen Bauelementen versehen. In einer Lötstation 17 werden die Bauelemente mit der Leiterplatte verlötet. In einer Prüfstation 18 werden die fertig bestückten Leiterplatten geprüft. In einer Vergießstation werden die Öffnungen in den Masken verschlossen, indem sie zum Beispiel mit einer Vergußmasse oder einem Heißkleber aufgefüllt werden. In einer Versandstation werden die fertigen Leiterplatten schließlich an die Abnehmer verschickt.

Durch das Verschließen der Öffnungen in der Leiterplatte, die die Bauelemente aufnehmen, mit einer Vergußmasse, entfällt in vielen Fällen die Notwendigkeit, die Baugruppe noch in einem Gehäuse unterzubringen. Die Bauelemente sind durch die Maske und die Vergußmasse in den Öffnungen gut vor Beschädigungen geschützt. Ein Gehäuse wird oft nur dann noch nötig sein, wenn es zum Beispiel aus ästhetischen Gründen mit einer vorgegebenen Lackierung versehen werden muß.

Zwei Masken 22 und 23, die mit Öffnungen 3 oder 7 versehen sind, können mit zwei schmalen Seitenwänden 24 und 25 und einer Hinterwand 26 zu einem taschenförmigen Behältnis 28 zusammengefaßt werden (Figur 4), in die die Leiterplatte (hier nicht dargestellt) nur noch eingesteckt zu werden braucht.

Die Öffnungen 3, 7 können, wenn eine sehr große Genauigkeit erforderlich ist, z.B. mit einem Laserstrahl aus der Maske 2 oder 9 herausgetrennt werden, nachdem die Maske durch Auftragen einer Beschichtungsmasse auf das Basismaterial der Leiterplatte hergestellt worden ist. Die Leiterplatte und die Maske können aber auch getrennt, z.B. durch Spritzgießen, hergestellt und anschließend formschlüssig miteinander verbunden werden, z.B. durch Kleben.

## Patentansprüche

1. Leiterplatte (1) mit einer Maske (2) zum Positionieren von mindestens einem Bauelement (4), die mit einer Öffnung versehen ist, die der Lage und den Abmessungen des Bauelements angepaßt ist,
**dadurch gekennzeichnet**,
- daß die Öffnung (3) mit einer schrägen Führungsfläche (5) versehen ist, die eine genaue Positionierung des Bauelements (4) bewirkt, und
- daß die Maske (2) im Bereich der Öffnung (7) eine Lagefixierung (10, 11) aufweist, durch die ein Montieren der Bauelemente (8) in verdrehter Lage verhindert wird.

2. Leiterplatte nach Anspruch 1, dadurch gekennzeichnet, daß die ein fertig montiertes Bauelement (4) aufnehmende Öffnung (3) mit einer Vergußmasse ausgefüllt ist.

3. Leiterplatte nach Anspruch 1, dadurch gekennzeichnet, daß sie auf ihren beiden Seiten je eine Maske (22, 23) aufweist und daß diese Masken zu einem Behältnis (28) zusammengefügt sind, in das die Leiterplatte an einer Schmalseite eingeführt wird.
